(19) Europäisches Patentamt
European Patent Office
Office européen des brevets

(11) Veröffentlichungsnummer: **0 171 445**
**A1**

(12) # EUROPÄISCHE PATENTANMELDUNG

(21) Anmeldenummer: **84109599.5**

(22) Anmeldetag: **11.08.84**

(51) Int. Cl.[4]: **H 01 L 29/94**
H 01 L 27/04, H 01 L 23/56

(43) Veröffentlichungstag der Anmeldung:
**19.02.86 Patentblatt 86/8**

(84) Benannte Vertragsstaaten:
**DE FR GB IT NL**

(71) Anmelder: **Deutsche ITT Industries GmbH**
**Hans-Bunte-Strasse 19 Postfach 840**
**D-7800 Freiburg(DE)**

(72) Erfinder: **Gollinger, Wolfgang**
**Reinhold-Schneider-Strasse 18A**
**D-7803 Gundelfingen(DE)**

(72) Erfinder: **Brüll, Jochen**
**Husserlstrasse 4**
**D-7800 Freiburg(DE)**

(74) Vertreter: **Morstadt, Volker, Dipl.-Ing.**
**c/o Deutsche ITT Industries GmbH**
**Patent/Lizenzabteilung Postfach 840 Hans-Bunte-Strasse 19**
**D-7800 Freiburg/Brsg.(DE)**

(54) **Monolithisch integrierte Schaltung mit einem integrierten MIS-Kondensator.**

(57) Die Si-Elektrode eines in Si-Gate-Technik realisierbaren integrierten MIS-Kondensator ist zur Erzielung einer hohen Güte des Kondensators in Form mindestens eines Elektrodenstreifens mit einem Randlängenverhältnis der Randlänge in Längserstreckung des Streifens zur Randlänge in Quererstreckung des Streifens von mehr als 100 : 1 ausgebildet. Er eignet sich besonders zur Reduzierung der Störstrahlung von VLSI-Schaltungen im Frequenzbereich von ca. 50 bis 100 MHz.

FIG. 2

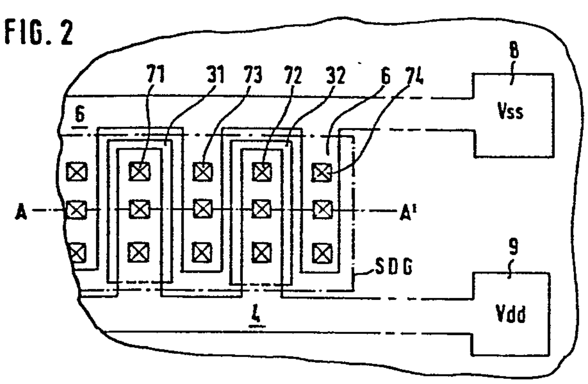


EP 0 171 445 A1

0171445

W. Gollinger et al 17-3

Fl 1217 EP
Go/Be
9.August 1984

## Monolithich integrierte Schaltung mit einem integrierten MIS-Kondensator

Die Erfindung beschäftigt sich mit einer monolithisch integrierten Schaltung mit einem integrierten MIS-Kondensator(Metall-Isolator-Silizium), welcher zwischen einer auf einer isolierenden Oberflächenschicht eines halbleitenden Substrats angebrachten Si-Elektrode und einer an der Oberfläche des Substrats gebildeten Inversionsschicht gebildet ist, wie aus der europäischen Offenlegungsschrift 93 818 bekannt ist. Bei diesem integrierten Kondensator ist an der Si-Elektrode über einen ersten Kontakt der erste Anschluß des MIS-Kondensators angebracht und der zweite Anschluß über mindestens eine Kontaktierungszone mit der Inversionsschicht verbunden. Der zweite Anschluß ist an einer über die Oberfläche der Kontaktierungszone der Inversionsschicht sich erstreckende zweite Kontaktierungsschicht angebracht.

Der integrierte MIS-Kondensator bei der bekannten monolithisch integrierten Schaltung ist mit der Ausgangsleitung einer Substratvorspannungsschaltung verbunden und übt daher eine Glättungs- und Pufferwirkung auf die Substratvorspannung aus, welche ebenfalls an einem Kontaktfleck liegt. In deren Oszillator fließen nur relativ kleine Ströme.

Bei einer monolithisch integrierten Schaltung mit einer hochfrequenten Generatorschaltung, insbesondere mit einer Taktgeneratorschaltung oder auch einer getakteten Logikschaltung, in der relativ große hochfrequente Ströme fließen, insbesondere in einer getakteten VLSI-Schaltung, wurde eine

um so größere elektromagnetische Störstrahlung festgestellt, je größere hochfrequente Ströme flossen. Als Ursache wurden die im Takte der Oszillatorfrequenz fließenden hochfrequenten Wechselströme auf den Versorgungsleitungen ermittelt. Versuche, diese Wechselströme durch einen äußeren, die beiden Versorgungsleitungen überbrückenden Kondensator abzublocken, blieben im wesentlichen ohne Erfolg. Die Erfindung beruht nun auf der Erkenntnis, daß nur ein mitintegrierter Kondensator hoher Güte, also mit sehr kleinem Bahnwiderstand und relativ großer Kapazität, Abhilfe schaffen kann und daß dieser Kondensator in einem derartig technologisch möglichst kleinen Abstand von den Versorgungsanschlüssen der Generatorschaltung oder der getakteten Logikschaltung die Versorgungsanschlüsse überbrückt, daß die Fläche der von den Wechselströme durchflossenen Stromschleife des Versorgungsstromkreises und damit auch die Störstrahlung minimal wird.

Aufgabe der Erfindung ist daher die Angabe eines integrierten MIS-Kondensators verbesserter Güte, welcher in Si-Gate-Technik herstellbar ist und der zusammen mit einer Zuleitungsinduktivität einen Resonanzkreis ergibt, der geeignet ist, die elektromagnetische Störstrahlung einer mitintegrierten Generatorschaltung oder auch einer getakteten Logikschaltung bis zu sehr hohen Störfrequenzen zu unterdrücken

Bei der vorstehend erwähnten Si-Gate-Technik, die beispielsweise in der Zeitschrift "Electronics" vom 29. September 1969, Seiten 88 bis 94, beschrieben wird, werden bekanntlich die Gateelektroden der Feldeffekttransistoren aus polykristallinem Silicium auf einer Gateoxidschicht gebildet und nach Freilegung der Halbleiteroberfläche in den Bereichen der Sourcezone und der Drainzone diese Zonen unter Verwendung der Si-Gate-Elektrode und der darunter liegenden Gateoxidschicht als Diffusionsmaske diffundiert bzw. unter Anwendung eines Ionenimplantationsprozesses eingebracht und anschließend diffundiert. Diese Technik, welche zu der Si-Elektrode selbstausgerichtete Zonen ergibt, bietet

sich zur Herstellung einer monolithisch integrierten Schaltung mit einem integrierten MIS-Kondensator nach der einleitend erwähnten europäischen Offenlegungsschrift 93 818 an.

Die Erfindung betrifft somit eine monolithich integrierte Schaltung gemäß dem Oberbegriff des Anspruchs 1, wie sie aus der genannten europäischen Offenlegungsschrift 93 818 bekannt ist, also mit einem MIS-Kondensator des Verarmungstyps.

Die vorstehend genannte Aufgabe wird erfindungsgemäß dadurch gelöst, daß die Si-Elektrode in Form mindestens eines Elektrodenstreifens mit einem Randlängenverhältnis der Randlänge in Längserstreckung des Streifens zur Randlänge in Quererstreckung des Streifens von mehr als 100 : 1 ausgebildet ist.

Vorzugsweise erfolgt der erste Anschluß an einer über die Oberfläche des Elektrodenstreifens bzw. der Elektrodenstreifen sich erstreckenden ersten Kontaktierungsschicht.

Durch die Maßnahmen einer direkten Kontaktierung der Si-Elektrode mit kleiner Kanallänge über kurze Zuleitungen ist ein sehr kleiner Serienzuleitungswiderstand zur Si-Elektrode und damit eine hohe Güte des integrierten MIS-Kondensators erzielbar.

Aus technologischen Gründen im Hinblick auf eine über die Fläche der Si-Elektrode oder auch der Kontaktierungszone bzw. der Kontaktierungszonen gleichmäßig erfolgenden Verbindung ist es günstig, daß die erste Kontaktierungsschicht den bzw. die Elektrodenstreifen mehrfach über gleichmäßig über die Flächenausdehnung des Elektrodenstreifens bzw. der Elektrodenstreifen verteilte Kontakte innerhalb von je einer Kontaktierungsöffnung einer Isolierschicht

kontaktiert und daß die zweite Kontaktierungsschicht die Kontaktierungszone(n) mehrfach über gleichmäßig über die Flächenausdehnung der Kontaktierungszone(n) verteilte Kontakte innerhalb je einer Kontaktierungsöffnung einer Isolierschicht kontaktiert.

Die Erfindung und ihre Vorteile werden in der folgenden Beschreibung an einem solchen bevorzugten Ausführungsbeispiel und anhand der Zeichnung erläuter, deren

Fig. 1 das Ersatzschaltbild des Ausschnittes einer monolithisch integrierten Schaltung mit einem MIS-Kondensators und einer mitintegrierten Generatorschaltung, insbesondere einer Taktgeneratorschaltung oder einer getakteten Logik, nach der Erfindung zeigt,

Fig. 2 eine Aufsicht auf die Hauptfläche einer integrierten Schaltung nach der Erfindung ausschnittsweise den integrierten MIS-Kondensator veranschaulicht,

Fig. 3 den Aufriß entlang der Schnittlinien A-A' der Fig. 2 zeigt und

Fig. 4 das Ersatzschaltbild des integrierten MIS- Kondensators einer monolithisch integrierten Schaltung nach der Erfindung bedeutet.

Die Fig. 1 zeigt schematisch das Ersatzschaltbild des Ausschnittes einer monolithisch integrierten Schaltung innerhalb der gestrichelten Linie 10, wie er zum Verständnis der Erfindung erforderlich ist. Am Rande der integrierten Schaltung sind die Anschlußflecken (pads) 8 und 9 angebracht, über die die Stromversorgung mit dem Strom Id der integrierten Generatorschaltung Gi erfolgt. Unter "integrierter Generatorschaltung" wird im Hinblick auf die der Erfindung zugrundeliegenden Aufgabe zumindest die

Leistungsendstufe einer selbtschwingenden oder von außerhalb der monolithisch integrierten Schaltung angesteuerten Generatorschaltung oder auch eine getaktete Logikschaltung verstanden. An einem äußeren Siebkondensator C2 liegt zwischen den beiden Potentialen Vdd und Vss die Wechselspannung Uc2. Als Beispiel wird angenommen, daß die integrierte Generatorschaltung Gi den übrigen getakteten Teil der monolithisch integrierten Schaltung mit Taktimpulsen versorgt, die an mindestens einem Taktausgang Ck über Leiterbahnen abgegriffen werden. Insbesondere bei hochintegrierten Schaltungen (VLSI) mit Leiterbahnen höherer Lastkapazitäten sind entsprechend große Taktimpulsströme erforderlich, die sich als sich überlagernde Störströme des gesamten Störstromes Is am Stromversorgungseingang der Generatorschaltung Gi, also auch im Stromkreis der Kontaktflecken 8 und 9, nach außen bemerkbar machen. Dieser Störstrom Is muß daher in seiner Auswirkung in Form einer elektromagnetischen Störstrahlung möglichst unschädlich gemacht werden. Dazu bietet sich beispielsweise ein äußerer Kondensator C2 oder auch ein integrierter Kondensator C1 an. Ein äußerer Kondensator C2 ist jedoch, wie festgestellt wurde, weitgehend unwirksam, da die elektromagnetische Störstrahlung der Fläche proportional ist, die vom Störstrom Is eingeschlossen wird, also bei Fehlen des integrierten Kondensators C1 von der Summe der beiden Flächen A1 und A2. Aufgrund dieser Erkenntnis erscheint es zwingend, die Entstörung einer monolithisch integrierten Schaltung mit einer integrierten Generatorschaltung Gi mittels eines möglichst großen Kondensators C1 möglichst nahe an den Versorgungsanschlüssen 11 und 12 der monolithisch integrierten Generatorschaltung Gi solchermaßen vorzunehmen, daß die Fläche A1, d.h. die vom Störstrom Is umschriebene Fläche, möglichst klein ist. In der Fig. 1 enthält die Ersatzschaltung des monolithisch integrierten Kondensators die Kapazität C1, den Reihenwiderstand R3 und die Ersatzinduktivität L3. Es kann bei einer Ansteuerung von einem außerhalb der integrierten Schaltung liegenden Oszillator ein Takteingang Ck' vorgesehen werden, der an einem besonderen Kontaktfleck liegt.

Das Ersatzschaltbild der Fig. 1 enthält im übrigen noch die integrierten Schutzwiderstände R1 und R2, sowie die Ersatzinduktivitäten L1 und L2, welche die Induktivitäten der Zuleitungen zum äußeren Kondensator enthalten, einschließlich die der Bonddrähte zu den äußeren Anschlüssen 14 und 15.

Um den Störstrom Is in einen kaum störenden Strom Id, der höchstens einen niederfrequenten Anteil aufweist, und einen hochfrequenten Strom Ic1 aufzuteilen, der störende elektrische Felder bewirken könnte, ist ein integrierter Kondensator C1 erforderlich, der einen möglichst geringen Serienwiderstand R3 und eine große spezifische Kapazität, d.h. eine möglichst große Kapazität pro Flächeneinheit, aufweist, um auf möglichst kleiner Fläche einen entstörenden Kondensator zu bilden. Einen solchen Kondensator zeigt nichtmaßstabsgerecht im Prinzip die Fig. 2 als Ausschnitt und Fig. 3 in Querschnittsansicht entlang der Schnittlinie A-A' der Fig. 2.

Die Schnittansicht der Fig. 2 läßt die Ähnlichkeit mit einem Si-Gate-Transistor erkennen, nämlich auf den Gateisolatorschichten 1 aufgebrachte Elektrodenstreifen 31 und 32, welche bei dem bei der Herstellung angewendeten Si-Gate-Prozeß als Diffusionsmaske zur Herstellung der Zone(n) 5 verwendet werden. Entsprechend diesem Prozeß wird außerhalb des von der SDG-Linie umschriebenen Bereiches eine relativ dicke Feldoxidschicht 13 erzeugt, welche beispielsweise unter Anwendung einer Oxidationsmaskierungsschicht hergestellt wurde. Nach Freilegung der Halbleiteroberfläche innerhalb des von der SDG-Maske definierten Bereiches des Halbleitersubstrats werden die extrem längstgestreckten Elektrodenstreifen 31, 32 und weitere erzeugt, indem die freiliegende Oberfläche der Anordnung mit einer polykristallinen dotierten Siliziumschicht bedeckt wird und daraus unter Anwendung eines photolitographischen Ätzprozesses

Elektrodenstreifen herausgeätzt werden. Das Randlängenverhältnis der Längserstreckung des Streifens zur Randlänge der Quererstreckung des Streifens sollte mindestens 100 : 1 betragen. Das Randlängenverhältnis bestimmt im Wesentlichen den Serienwiderstand R3 und damit die Güte des Kondensators. Die Güte des Kondensators ist nämlich gegeben durch 1/w.C1. R3, ein Wert, der möglichst groß werden soll. Die Grenze der erzielbaren Güte ergibt sich aus der Genauigkeit der angewendeten photolitographischen Ätzprozesse. Weiteren Einfluß auf die Güte haben natürlich auch die Schichtwiderstände der Kontaktierungszone(n) 5, des Elektrodenmaterials und der Kontaktierungsschichten 4,6.

Das Ersatzschaltbild einer solchen MIS-Kapazität ist aus der Fig. 4 ersichtlich und zeigt einen MIS-Feldeffekttransistor, dessen Sourcezone mit der Drainzone kurzgeschlossen ist. Dieser Kurzschluß kann sowohl mittels der zweiten Kontaktierungsschicht 6 als auch gemäß der Fig. 2 dadurch erzielt werden, daß an der Stirnfläche der Elektrodenstreifen 31 und 32 und dem Rand der Feldoxidschicht 13 ein Abstand verbleibt, so daß bei der Source-Drain-Diffusion die Elektrodenstreifen von den Kontaktierungszonen 12, welche sich zu einer gemeinsamen vereinigen, umgeben sind. Die Kontaktierungsschichten 4 und 6 werden vorzugsweise kammförmig und ineinandergreifend ausgebildet, wie die Fig. 2 zeigt.

Wird mit $w_{min}$ die kleinste störende Kreisfrequenz und mit $w_{max}$ die höchste störende Kreisfrequenz der vom Störstrom Is bewirkten Störstrahlung bezeichnet, so sollte angestrebt werden:

$$C1 > \frac{1}{w^2_{min} \cdot (L1 + L2)}, \quad w_{max} \cdot C1.R3 \ll 1; \text{ und } w^2_{max} \cdot C1.L3 < 1,$$

wobei die Serienresonanzfrequenz von C1, L3 höher als $f_{max}$ liegt und C2 $\gg$ C1 angenommen wird.

Für die zwischen den äußeren Anschlußflecken gemessene Störspannung $U_{C2}$ gilt die Beziehung:

$$U_{C2} = \frac{Is}{w.(C1 + C2) . (1 - \frac{w^2}{w_o^2})}$$

mit $w_o^2 = \frac{C1 + C2}{C1 . C2.(L1 + L2)}$

für R1, R2, R3, L3 = O.

Es können im praktischen Fall ohne weiteres MIS-Kondensatoren mit relativ kleinem Flächenbedarf realisiert werden, welche 100 bis 200 pF aufweisen.

Zur Realisierung eines kleinen Bahnwiderstandes R3 der integrierten MIS-Kapazität muß jeder der Elektrodenstreifen gleichmäßig und niederohmig über seine Oberfläche kontaktiert werden. Dies kann entweder über die gesamte Oberfläche des Elektrodenstreifens gleichmäßig mittels einer ersten Kontaktierungsschicht erfolgen, welche bis auf einen Randstreifen den Elektrodenstreifen niederohmig kontaktiert, oder auch mittels einer Kontaktierungsschicht 4, welche den bzw. die Elektrodenstreifen 31 und 32 mehrfach über gleichmäßig über die Flächenausdehnung des Elektrodenstreifens bzw. der Elektrodenstreifen 31 und 32 verteilte Kontakte kontaktiert, welche je eine Kontaktierungsöffnung einer Isolatorschicht 7 durchgreifend den bzw. die Elektrodenstreifen 31 und 32 kontaktieren. In gleicher Weise kann bei den Kontaktierungszonen 5 verfahren werden, indem die zweite Kontaktierungsschicht 6 die Kontaktierungszone(n) 5 mehrfach über gleichmäßig sich über die Flächenausdehnung der Kontaktierungszone(n) 5 verteilte Kontakte innerhalb je einer Kontaktierungsöffnung 73 und 74 einer Isolatorschicht 7 kontaktiert. Die Kontaktierungsschichten 4 und 5 sollten

natürlich aus einem Material bestehen, dessen spezifischer Widerstand geringer ist als der des Siliziums der Elektrodenstreifen, also aus einem Metall oder auch aus einem Metallsilizid.

Bei der Verminderung der Störstrahlung der integrierten Generatorschaltung Gi einer VLSI-Schaltung wurden entsprechend den in Verbindung mit den Fig. 1 und 2 dargelegten Gesichtspunkten die Stromversorgungsanschlüsse 11 und 12 unmittelbar an den integrierten MIS-Kondensator angeschlossen, so daß die vom Störstrom Is eingeschlossene strahlende Fläche sehr klein wurde. Es ließ sich erreichen, daß bis ca. 500 MHz der ohmsche Serienwiderstand R3 kleiner als der kapazitive Widerstand 1/wC1 und der induktive Serienwiderstand wL3 wegen der kurzen Anschlußleitung ebenfallsbis ca. 500 MHz kleiner als der kapazitive Widerstand 1/wC1 blieb. Bei dem in der Fig.2 gestrichelt gezeigten Verlauf der Kontaktierungsschichten 6 und 4 wurde zum besseren Schutz des integrierten MIS-Kondensators in Serie zu den Versorgungsleitungen die Schutzwiderstände R1 und R2 eingefügt.

## Patentansprüche

1. Monolithisch integrierte Schaltung mit einem integrierten MIS-Kondensator,
   - der zwischen einer auf einer isolierenden Oberflächenschicht eines halbleitenden Substrats aufgebrachten Si-Elektrode, an der über eine erste Kontaktierungsschicht der erste Anschluß des MIS-Kondensators angebracht ist, und einer an der Oberfläche des Substrats gebildeten Inversionsschicht, welche über mindestens eine Kontaktierungszone mit dem zweiten Anschluß des MIS-Kondensators verbunden ist, gebildet ist,
   - wobei der zweite Anschluß an einer über die Oberfläche der Kontaktierungszone sich erstreckenden zweiten Kontaktierungsschicht angebracht ist,

   dadurch gekennzeichnet,
   - daß die Si-Elektrode (3) in Form mindestens eines Elektrodenstreifens mit einem Randlängenverhältnis der Randlänge in Längserstreckung des Streifens zur Randlänge in Quererstreckung des Streifens von mehr als 100:1 ausgebildet ist.

2. Monolithisch integrierte Schaltung nach Anspruch 1, dadurch gekennzeichnet, daß ein erster Anschluß des MIS-Kondensators gleichmäßig an einer über die Oberfläche des Elektrodenstreifens bzw. der Elektrodenstreifen (31, 32) sich erstreckenden ersten Kontaktierungsschicht (4) erfolgt.

3. Monolithisch integrierte Schaltung nach Anspruch 1, dadurch gekennzeichnet,
   - daß die erste Kontaktierungsschicht (4) den Elektrodenstreifen bzw. die Elektrodenstreifen (31. 32) mehrfach über gleichmäßig über die Flächenausdehnung des Elektrodenstreifens bzw. der Elektrodenstreifen (31, 32) verteilte Kontakte innerhalb von je einer Kontaktierungsöffnung einer Isolatorschicht (7) kontaktiert und
   - daß die zweite Kontaktierungsschicht (6) die Kontaktierungszone(n) (5) mehrfach über gleichmäßig sich über die Flächenausdehnung der Kontaktierungsszone(n) (5) verteilte Kontakte innerhalb je einer Kontaktierungsöffnung (73, 74) einer Isolierschicht (7) kontaktiert.

4. Monolithisch integrierte Schaltung nach Ansprüche 1 bis 3, dadurch gekennzeichnet, daß die Kontaktierungsschichten (4, 6) mit den sie verbindenden Teilen kammförmig ineinandergreifend ausgebildet sind.

5. Monolithisch integrierte Schaltung nach einem der Ansprüche 1 bis 4, dadurch gekennzeichnet, daß sie eine Generatorschaltung (Gi) oder eine getaktete Logikschaltung enthält, deren Spannungsversorgungsanschlüsse (8, 9) von dem integrierten MIS-Kondensator in nächster Nähe der Stromversorgungsanschlüsse (11,12) überbrückt sind.

FIG. 1

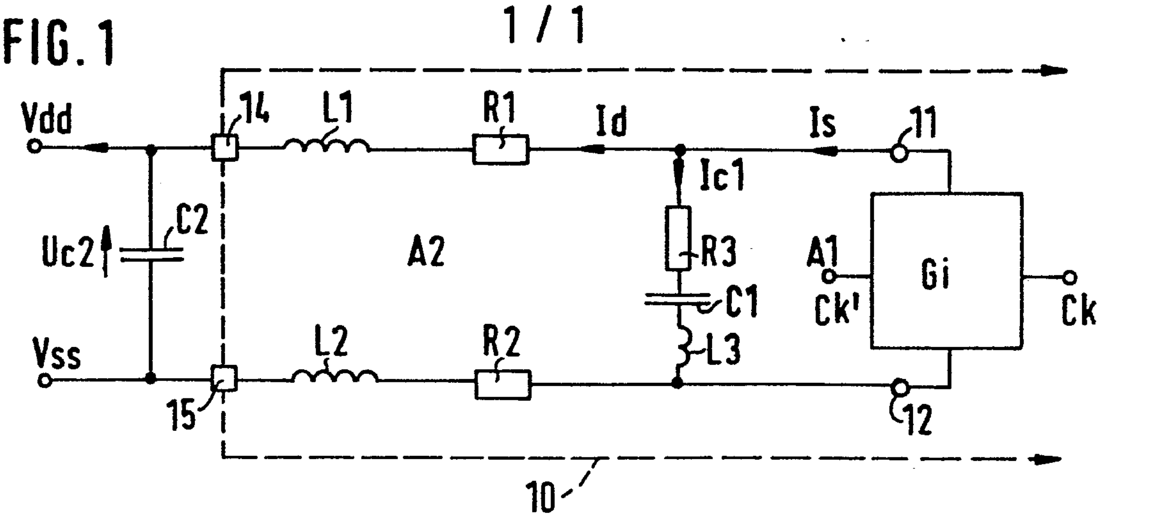


FIG. 2

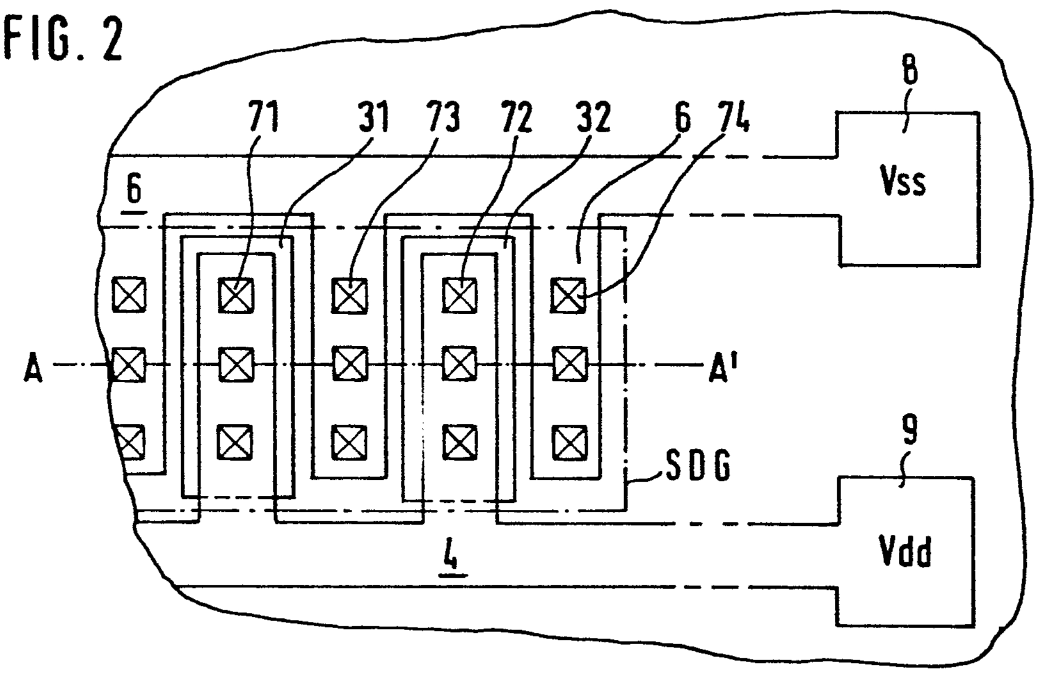


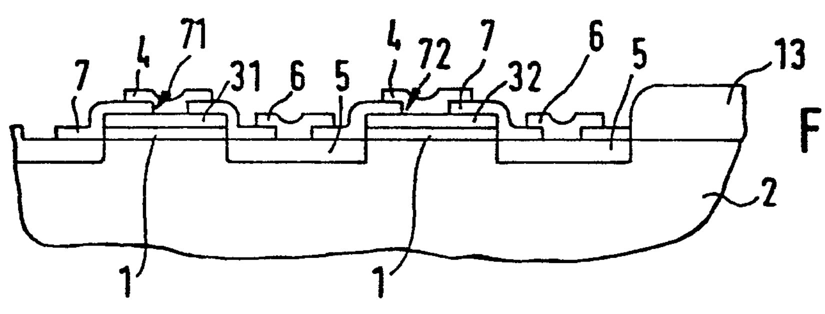


FIG. 3

FIG. 4

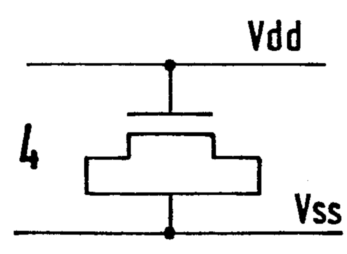

Europäisches Patentamt

# EUROPÄISCHER RECHERCHENBERICHT

0171445

Nummer der Anmeldung

EP 84 10 9599

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| A | DE-A-1 940 300 (RCA)<br>* Ansprüche 1,5; Seite 4; Figur 5 * | 1-4 | H 01 L 29/94<br>H 01 L 27/04<br>H 01 L 23/56 |
| A | FR-A-2 124 353 (TRW INC.)<br>* Ansprüche 1,5,19; Seite 7, Zeile 38 - Seite 8, Zeile 37; Seite 16, Zeilen 5-20; Figuren 1,3a,3b,4,6 * | 1,2,5 | |
| A | FR-A-2 024 788 (GENERAL ELECTRIC CO.)<br>* Anspruch 2; Seite 10, Zeile 31 - Seite 11, Zeile 35; Figuren 4-6 * | 1-4 | |
| A | PATENT ABSTRACTS OF JAPAN, Band 8, Nr. 149, 12. Juli 1984, Seite (E-255) (1586); & JP-A-59-54248 (FUJITSU K.K.) 29-03-1984 | | RECHERCHIERTE SACHGEBIETE (Int Cl 4) |
| A | ELEKTRONIK, Heft 5, 1973, München; L. TALAMONTI "Binäre Kapazitäten in MOS-Schaltungen", Seiten 179-181<br>* Bilder 1,2 * | | H 01 L 23/56<br>H 01 L 27/02<br>H 01 L 29/94 |

Der vorliegende Recherchenbericht wurde für alle Patentansprüche erstellt

| Recherchenort | Abschlußdatum der Recherche | Prüfer |
|---|---|---|
| BERLIN | 27-03-1985 | ROTHER A H J |

KATEGORIE DER GENANNTEN DOKUMENTEN

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82